# EUROPÄISCHE PATENTSCHRIFT

(11) **EP 1 412 978 B1**
(45) Veröffentlichungstag und Bekanntmachung des Hinweises auf die Patenterteilung: **13.10.2010**
(21) Anmeldenummer: 02754459.2
(22) Anmeldetag: 31.07.2002
(51) Int. Cl.: H01L 23/31, H01L 21/68, H01L 21/56

(54) **ELEKTRONISCHES BAUTEIL MIT EINEM KUNSTSTOFFGEHÄUSE UND VERFAHREN ZU SEINER HERSTELLUNG**
ELECTRONIC COMPONENT WITH A PLASTIC HOUSING AND METHOD FOR PRODUCTION THEREOF
COMPOSANT ELECTRONIQUE MUNI D'UN BOITIER PLASTIQUE ET PROCEDE PERMETTANT DE LE PRODUIRE

(30) Priorität: 31.07.2001 DE 10137184
(43) Veröffentlichungstag der Anmeldung: 28.04.2004
(73) Patentinhaber: Infineon Technologies AG, 85579 Neubiberg (DE)
(72) Erfinder: GOLLER, Bernd, 95478 Kemnath (DE); HAGEN, Robert-Christian, 93092 Sarching (DE); OFNER, Gerald, 93077 Bad Abbach (DE); STÜMPFL, Christian, 92421 Schwandorf (DE); WEIN, Stefan, 93138 Lappersdorf (DE); WÖRNER, Holger, 93049 Regensburg (DE); THUMBS, Josef, 92363 Breitenbrunn (DE)
(74) Vertreter: Schäfer, Horst
(86) Internationale Anmeldenummer: PCT/DE2002/002811
(87) Internationale Veröffentlichungsnummer: WO 2003/015165

(56) Entgegenhaltungen:
- WO-A-01/35461
- FR-A- 2 704 690
- US-A- 5 977 641
- US-A- 5 989 982
- PATENT ABSTRACTS OF JAPAN vol. 1997, no. 04, 30. April 1997 (1997-04-30) -& JP 08 330472 A (TOPPAN PRINTING CO LTD), 13. Dezember 1996 (1996-12-13)
- WINDERL J ET AL: "WAVERLEVELASSEMBLY UNTER BERUECKSICHTIGUNG EINER CHIPKANTENSTRUKTURMIT VERBESSERTER ZUVERLAESSIGKEIT FUER BARE-DIE-PACKAGES (BDP) UND MICRO BARE-DIE-PACKAGE (MUBDP)" , TECHNIK REPORT, SIEMENS AG.,ERLANGEN, DE, VOL. 3, NR. 8, PAGE(S) 27-28 XP000936322 ISSN: 1436-7777 das ganze Dokument
- PATENT ABSTRACTS OF JAPAN vol. 1996, no. 07, 31. Juli 1996 (1996-07-31) -& JP 08 070081 A (NIPPONDENSO CO LTD), 12. März 1996 (1996-03-12)

## Beschreibung

Die Erfindung betrifft ein elektronisches Bauteil mit Kunststoffgehäuse und Verfahren zu seiner Herstellung entsprechend der Gattung der unabhängigen Ansprüche.

Die zunehmende Komplexität der Herstellung von elektronischen Bauteilen aus einem Kunststoffgehäuse mit einem Halbleiterchip und auf der Unterseite des Kunststoffgehäuses verteilten Außenkontakten führt zunehmend zu höherem Ausschuß bei der Herstellung derartiger elektronischer Bauteile. Darüber steigen die Herstellungskosten für solche elektronischen Bauteile mit zunehmender Anzahl von Außenkontakten auf dessen Unterseite.

Die FR 2 704 690 offenbart ein Verfahren zum Einhüllen von Halbleiterchips und ein elektronisches Bauteil, das durch dieses Verfahren hergestellt wird. Dabei werden zunächst Verdrahtungen direkt auf einen Halbleiterwafer aufgebracht und der Halbleiterwafer auf eine elastische Schicht aufgeklebt. Danach wird der Halbleiterwafer auseinandergesägt, um die Halbleiterchips zu vereinzeln. Anschließend werden die elastische Schicht auseinandergezogen und die Halbleiterchips ausgebreitet. Dann werden die Halbleiterchips mit ihren Verdrahtungen in einem isolierenden Material z.B. einem Kunstharz eingehüllt. Danach wird die Oberfläche des aufgebrachten isolierenden Materials so abgeschliffen, dass die metallischen Anschlussflächen auf den Verdrahtungen frei zugänglich sind und von außen kontaktiert werden können. Schließlich werden die elektronischen Bauteile mit den Halbleiterchips durch Sägen vereinzelt.

In der US 5,989,982 ist ein Verfahren zur Herstellung von Halbleiterbauteilen beschrieben. Dabei wird zunächst ein Halbleiterwafer mit einem Diamantsägeblatt in einzelne Abschnitte zerteilt. Danach wird die gesamte Oberfläche des Halbleiterwafers, die nun Lücken zwischen den einzelnen Abschnitten aufweist, mit einem Harz vergossen. Danach wird der Halbleiterwafer mittels einem sehr dünnen Diamantsägeblatt in einzelne Abschnitte zersägt. Dadurch erhält man ein chip size package, in dem zumindest noch auf der aktiven Oberseite des Halbleiterchips Kunstharz verblieben ist. Durch dieses Verfahren ist es auch möglich, chip size packages bereitzustellen, bei denen auch die Seitenflächen der Halbleiterchips mit einem Kunstharz versehen sind.

Aus der JP 08330472 ist ein Halbleiterbauteil bekannt, bei dem ein Halbleiterchip auf einem metallischen Substrat bspw. eines lead frames montiert ist und bei dem ein Golfball durch ball bonding auf die Kontaktansclußfläche eines Halbleiterchips aufgebracht ist. Das Halbleiterbauteil ist mit Kunstharz vergossen, so dass die Oberfläche des Goldballs frei zugänglich ist. Das Halbleiterbauteil ist mittels Lotbällen auf einem externen Schaltkreis befestigt.

Das Dokument Winderl J et al: "Waverlevelassembly unter Berücksichtigung einer Chipkantenstruktur mit verbesserter Zuverlässigkeit für Bare-Die-Packages (BDP) und micro Bare-Die-Package (µBDP)", Technik Report, Siemens AG, Erlangen, DE, Vol. 3, Nr. 8, Pages 27-28, XP000936322, ISSN: 1436-7777 offenbart ein Verfahren, bei dem bereits im Herstellungsprozess eine Verkapselung eines Halbleiterchips erreicht wird.

In der JP 08070081 ist ein Halbleiterbauteil beschrieben, bei dem ein auf seiner aktiven Oberseite mit einem Schutzfilm versehener Halbleiterchip so in eine Kunstharzmasse eingegossen ist, dass Führungsstifte, die mit den Kontaktflächen auf der aktiven Oberseite des Halbleiterchips in Verbindung stehen, auf der Oberseite des Halbleiterbauteils herausstehen.

Die US 5,977,641 zeigt ein Halbleiterbauelement mit einer chip size package Struktur. Dieses Halbleiterbauelement umfasst einen Halbleiterchip, Verdrahtungen, eine Vielzahl von Außenkontaktflächen mit darauf angeordneten Außenkontakten, eine Schutzschicht und eine Isolationsschicht. Die Isolationsschicht dient auch als Versiegelungsschicht und ist so ausgebildet, dass sie die gesamte Oberfläche des Halbleiterchips abdeckt und nur Abschnitte mit Durchgangslöchern oberhalb der Kontaktflächen der Halbleiterchips freilässt. Umverdrahtungen erstrecken sich von den Durchgangslöchern zu den Außenkontakten auf der Isolationsschicht.

Es ist Aufgabe der Erfindung, ein elektronisches Bauteil und ein Verfahren zu dessen Herstellung zu schaffen, bei dem trotz zunehmender Komplexität und zunehmender Zahl von Außenanschlüssen die Ausschußrate verringert und das trotzdem preiswert herstellbar ist.

Intensive Untersuchungen haben ergeben, daß ein wesentlicher Grund der Verteuerung der Herstellung von komplexen Bauteilen mit einem Kunststoffgehäuse in der Vielzahl von Montagetechniken für alle möglichen Gehäuseformen liegt, da es keine einheitliche Technologieplattform gibt. Die Technologien zur Herstellung verschiedener Gehäuse und Gehäusefamilien sind bisher völlig unterschiedlich. Außerdem erscheint der Einsatz von Interposern und definierter Chipträger und anderer Systemträger unverzichtbar. Insbesondere die technisch aufwen-dige Umverdrahtungsfunktion eines Interposers birgt jedoch ein ständiges Funktionsrisiko. Bei dem erfindungsgemäßen elektronischen Bauteil mit Kunststoffgehäuse kann auf den Einsatz eines Interposers vollständig verzichtet werden.

Erfindungsgemäß weist ein elektronisches Bauteil die in Anspruch 1 angegebenen Merkmale auf.

Dieses elektronische Bauteil hat den Vorteil, daß es eine kostengünstige Gehäusealternative für hochintegrierte und hochpolige Bauformen ohne Einsatz von Mehrlagensubstraten und zusätzlichen Interposern bietet. Gleichzeitig wird mit den Kontaktsäulen, die eine elektrisch leitende Überhöhung der Kontaktflächen auf der aktiven Oberseite des Halbleiterchips darstellen, eine neue Montagetechnik als Technologieplattform für alle möglichen Gehäuseformen verwirklicht. Das Herstellen von Kontaktsäulen auf den Kontaktflächen des in eine Kunststoffgehäusemasse eingebetteten Halbleiterchip liefert eine neue Technologie zur Herstellung verschiedener Gehäuse und Gehäusefamilien bei immer gleichbleibenden Grundstrukturen.

Mit dem erfindungsgemäßen elektronischen Bauteil sind hochintegrierte Bauteile in zukünftigen Technologien wie den Fan-Out-Designs ebenso herstellbar wie Low-Pin-Count-Anwendungen mit hohen Anforderungen an die Performance bis hin zu Wafer-Level-Packages. Mit diesem elektronischen Bauteil wird gleichzeitig die Schwierigkeit überwunden, daß bisher unterschiedliche Gehäuseformen stets neue Konzepte für Fertigungslinien und somit unterschiedlichstes Equipment, Prozesse und Materialien erfordern, was mit dem erfindungsgemäßen elektronischen Bauteil entfällt. Die unterschiedlichen Ansätze für Gehäuse auch im Anwendungsbereich der Hochfrequenztechnik und der High-Pin-Count-Gehäuse wie dem P-LFBGA-Gehäuse können auf der Basis des erfindungsgemäßen elektronischen Bauteils vereinheitlicht und vereinfacht werden.

Zwischen der Kunststoffschicht und der Umverdrahtungsebene bzw. zwischen der Kunststoffschicht und einer der Umverdrahtungsebenen kann auch wenigstens eine weitere elektrisch isolierende Zwischenschicht vorgesehen sein. Für bestimmte Anwendungen können sich daraus weitere Vorteile im Hinblick auf mechanische oder elektrische Eigenschaften des erfindungsgemäßen Bauteils ergeben.

Bauteile mit besonders kleinen Halbleiterchips lassen sich dann noch gut kontaktieren, wenn Außenkontakte in Bereichen unterhalb der Seitenränder des Kunststoffgehäuses angeordnet sind. Mit dieser Ausführungsform der Erfindung kann die Anzahl der Außenkontakte auch beliebig erhöht werden, indem die Seitenränder aus Kunststoffgehäusemasse beliebig größer als die Seitenränder des Halbleiterchips gestaltet werden.

Die Außenkontakte können dabei auch über Kontaktsäulen des Halbleiterchips und über auf der Kunststoffgehäusemasse angeordnete Umverdrahtungsleitungen mit Kontaktflächen auf der aktiven Oberseite des Halbleiterchips verbunden sein. Dann sind die Kontaktsäulen als elektrisch leitende Überhöhung der Kontaktflächen ausgebildet.

In einer Ausgestaltung der Erfindung ist es vorgesehen, daß die Rückseite des Halbleiterchips auf der Oberseite des Kunststoffgehäuses angeordnet ist und eine Außenkontaktfläche für ein Massepotential aufweist. Diese Außenkontaktfläche kann auch für den Anschluß eines Wärmeleitungsblockes oder einer Kühlvorrichtung genutzt werden. Ein Vorteil dieses elektronischen Bauteils besteht darin, daß nicht nur Außenkontakte auf der Unterseite des elektronischen Bauteils angeordnet sind, sondern nun auch eine zentrale Außenkontaktfläche auf der Oberseite des elektronischen Bauteils angeboten wird.

Bei einer weiteren Ausführungsform der Erfindung ist die Rückseite des Halbleiterchips unterhalb der Oberseite des Kunststoffgehäuses angeordnet und von einer Beschichtung aus Kunststoffgehäusemasse bedeckt. Diese Ausführungsform der Erfindung hat den Vorteil, daß die Rückseite des Halbleiterchips durch die Beschichtung aus Kunststoffgehäusemasse vor mechanischen Beschädigungen geschützt ist.

Bei dem erfindungsgemäßen elektronischen Bauteil können die Umverdrahtungsleitungen wenigstens teilweise unmittelbar auf der Kunststoffgehäusemasse aufliegen. Eine etwaige Gefahr, die daraus resultiert, beim Aufbringen von Außenanschlüssen auf Außenkontaktflächen auch die Umverdrahtungsleitungen vom Material der Außenkontakte benetzt werden, wird gemäß der Erfindung auf einfache Weise dadurch vermieden, daß auf der Unterseite des elektronischen Bauteils eine Lötstoppschicht vorgesehen wird, bei der Außenkontaktflächen der Außenkontakte freibleiben.

Die Außenkontakte selbst können als Lötbälle oder Löthöcker ausgeführt sein. Derartige Lötbälle und Löthöcker haben den Vorteil, daß sie auf der gesamten Unterseite des Kunststoffgehäuses angeordnet werden können, sofern entsprechend viele Außenkontaktflächen auf der Unterseite des elektronischen Bauteils angeordnet werden.

Erfindungsgemäß ist eine mehrschichtige Leiterbahnstruktur vorgesehen. Diese mehrschichtige Leiterbahnstruktur dient der Umverdrahtung von den Kontaktsäulen des Halbleiterchips zu den vorgesehenen Außenkontakten. Die Erfindung hat dadurch den Vorteil, daß die mehrschichtige Leiterbahnstruktur auf Kontaktsäulen des Halbleiterchips aufbauen kann, die in Kunststoffgehäusemasse eingebettet sind und deren Oberseiten frei von Kunststoffmasse bleiben, so daß die unterste Leiterbahnlage der mehrschichtigen Leiterbahnstruktur unmittelbar auf der Kunststoffgehäusemasse aufliegt und mit den Kontaktsäulen des Halbleiterchips verbunden ist.

Ein Verfahren zur Herstellung eines elektronischen Bauteils mit einem Kunststoffgehäuse, in dem ein Halbleiterchip angeordnet ist, weist die im Anspruch 6 aufgeführten Verfahrensschritte auf.

Dieses Verfahren hat den Vorteil, daß es eine Technologieplattform für alle möglichen Gehäuseformen bietet. Dabei bleibt die Technologie zur Herstellung verschiedener Gehäuse und Gehäusefamilien immer die gleiche. Auf den Einsatz von Interposern oder definierten Chipträgern kann bei diesem Verfahren zur Herstellung eines elektronischen Bauteils verzichtet werden. Mit dem Verfahren ist jedes beliebige Pin-Design erzeugbar. Auch hochintegrierte Bauteile in zukünftigen Technologien wie den Fan-Out-Designs sind herstellbar genauso wie Low-Pin-Count-Anwendungen mit hohen Anforderungen an die Performance bis hin zu Wafer-Level-Packages.

Mit dem erfindungsgemäßen Verfahren können aufwendige Umverdrahtungsfunktionen eines üblichen Interposers vollständig ersetzt werden. Schließlich liefert das erfindungsgemäße Verfahren eine kostengünstige Gehäusealternative für hochintegrierte und hochpolige Bauformen ohne Einsatz von Mehrlagensubstraten und zusätzlichen Interposern. Mit diesen Verfahren sind sowohl Einlagenverdrahtungen unmittelbar auf dem Träger aus Kunststoffgehäusemasse möglich wie Mehrlagenaufbauten. Auch können beliebige Anschlußmuster auf der Unterseite des elektronischen Bauteils mit diesem Verfahren hergestellt werden. Für unterschiedliche Gehäuse wie beispielsweise VQFN- oder P-LFBGA-Gehäusen besteht technologisch kein Unterschied. Somit sind das erfindungsgemäße Verfahren und die zugehörigen Prozesse gehäuseunabhängig.

Eine Fortbildung des erfindungsgemäßen Verfahrens sieht vor, daß die Unterseite des Halbleiterwafers vor dem Trennen in Halbleiterchips mit einer Beschichtung aus Kunststoffgehäusemasse versehen wird. Dies hat den Vorteil, daß zunächst ein ganzer Halbleiterwafer auf seiner Unterseite mit einer Kunststoffgehäusemasse versehen wird, so daß nach dem Trennen in einzelne Halbleiterchips diese bereits auf ihrer Rückseite mit einer Kunststoffgehäusemasse versehen sind. Das Einbetten der Rückseite und damit der Schutz der Rückseite durch die Kunststoffgehäusemasse ist dann bereits erfolgt, bevor eine Weiterverarbeitung des Chips zu einem elektronischen Bauteils erfolgt.

In einem weiteren Durchführungsbeispiel des Verfahrens erfolgt das säulenförmige Überhöhen der Kontaktflächen zu Kontaktsäulen auf dem Halbleiterchip und damit auf dem Halbleiterwafer mittels Metallabscheidung durch eine Maske hindurch. Nach Abziehen der Maske verbleiben metallische säulenförmige Überhöhungen auf den Kontaktflächen der jeweiligen Halbleiterchips des Halbleiterwafers stehen.

Das säulenförmige Überhöhen der Kontaktflächen zu Kontaktsäulen auf dem Halbleiterchip kann auch mittels selektiver elektrolytischer Metallabscheidung durch eine Maske hindurch erfolgen. Dazu wird zunächst auf dem Halbleiterwafer eine geschlossene Metallschicht von weniger als 1 µm aufgebracht. Anschließend wird eine Maske auf den Wafer entweder aufgedruckt oder durch Photolacktechnik aufgebracht und schließlich wird an die durchgehende Metallschicht ein Kathodenpotential einer Galvanikanlage gelegt, so daß auf den von der Maske freigehaltenen Kontaktflächen auf dem Halbleiterwafer galvanisch oder elektrolytisch Kontaktsäulen abgeschieden werden. Anschließend wird die Maske abgenommen. Das kann beispielsweise durch Veraschung in einem Plasmaofen erfolgen oder durch Lösungsmittel, die die Maske wegschwemmen, und abschließend wird durch eine kurze Ätzung die dünne verbindende Metallschicht abgeätzt, so daß die einzelnen Kontaktsäulen nicht mehr kurzgeschlossen sind. Dieses Durchführungsbeispiel hat den Vorteil, daß es eine äußerst preiswerte Variante ist, die für die Massenherstellung von Kontaktsäulen auf einem Halbleiterwafer geeignet ist.

Zur säulenförmigen Überhöhung der Kontaktflächen zu Kontaktsäulen auf dem Halbleiterchip können auch Drucktechniken verwendet werden. Derartige Drucktechniken haben den Vorteil, daß keine Maske unmittelbar auf dem Halbleiterwafer aufgebracht werden muß, die anschließend zerstört wird. Vielmehr kann eine dauerhafte Schablone oder Maske eingesetzt werden, durch die ein Drucken der Kontaktsäulen erfolgen kann. Der Druckvorgang selbst benötigt nur eine geringe Prozesszeit, so daß auch er für eine Massenfertigung geeignet ist.

Die säulenförmigen Überhöhungen der Kontaktflächen zu Kontaktsäulen auf dem Halbleiterchip können auch unter Einsatz von Metallaufstäubung durch eine Maske erfolgen. Dieses Metallaufstäuben bzw. Sputtern erfolgt, indem eine metallische Quelle, beispielsweise mit Elektronenstrahlen oder Inertionenstrahlen, zerstäubt wird und anschließend diese zerstäubten Metallionen in Richtung auf einen auf Kathodenpotential liegenden Wafer aufgestäubt werden. Dieses Aufstäuben kann durch eine Maske hindurch erfolgen, oder es kann auch eine geschlossene Metallfläche erzeugt werden, die anschließend mit Hilfe von Photolacktechnik zu Kontaktsäulen strukturiert wird.

Anstelle einer Aufstäubungstechnik kann auch eine Aufdampfungstechnik angewandt werden, bei der eine Metallquelle verdampft wird und dieser Metalldampf die Oberseite des Halbleiterwafers beschichtet. Dieses Beschichten kann wiederum durch eine Maske erfolgen oder es kann anschließend eine Maske aufgebracht werden, um selektiv lediglich die Metallsäulen auf dem Halbleiterchip bzw. Halbleiterwafer auszubilden.

Schließlich können die säulenförmigen Überhöhungen der Kontaktflächen zu Kontaktsäulen auch mittels Aufbringen von Bondköpfen erzeugt werden. Derartige Bondköpfe können Thermosonickompressionsköpfe sein, bei denen ein Golddraht zu einem säulenförmigen Kopf umgeformt wird. Diese säulenförmigen Erhöhungen haben den Vorteil, daß sie beliebige Überhöhungen der Kontaktflächen herstellen können. Der weitere Vorteil dieser Überhöhung liegt darin, daß sie eine sehr formstabile Kontaktsäule auf dem Halbleiterchip bilden.

Nach dem Herstellen der Kontaktsäulen kann der Halbleiterwafer in eine Kunststoffgehäusemasse verpackt werden. Soll die Unterseite des elektronischen Bauteils wesentlich größer als die Fläche eines Einzelchips ausgeführt werden, dann wird zunächst der Halbleiterwafer in einzelne Halbleiterchips aufgetrennt. Nach dem Auftrennen können die Chips in beliebigem Abstand voneinander in Zeilen und Spalten auf einer Formplatte aufgebracht werden. Ist die Formplatte bestückt, dann kann die gesamte Formplatte mit einer Kunststoffgehäusemasse beschichtet werden, wobei die Halbleiterchips gemeinsam in die Kunststoffgehäusemasse eingebettet sind. Die Oberseiten der Kontaktsäulen auf der Oberseite des Trägers aus Kunststoffgehäusemasse sind dabei noch frei zugänglich. Dies hat den Vorteil, daß anschließend für viele Halbleiterchips gleichzeitig Umverdrahtungsleitungen unmittelbar auf der Kunststoffgehäusemasse aufgebracht werden können. Ferner hat es den Vorteil, daß beliebig viele Außenkontakte auf der Unterseite des elektronischen Bauteils plaziert werden können, indem auf dem Träger aus Kunststoffgehäusemasse entsprechend viele Kontaktanschlussflächen über Umverdrahtungsleitungen vorgesehen werden.

In einem weiteren Durchführungsbeispiel des Verfahrens erfolgt ein selektives Aufbringen von Umverdrahtungsleitungen auf dem gemeinsamen Träger aus Kunststoffgehäusemasse durch Aufbringen einer geschlossenen Metallschicht und anschließender Strukturierung der Metallschicht mittels Photolacktechnik. Dieses Verfahren hat den Vorteil, daß zunächst mittels Aufstäuben von Metall oder Aufdampfen von Metall oder stromlosen Abscheiden von Metall eine geschlossene Metallschicht auf der Oberseite des Trägers aus einer Kunststoffgehäusemasse gebildet wird, die alle Oberseiten der Kontaktsäulen zunächst kurzschließt und anschließend wird durch eine präzise Photolacktechnik diese Schicht zu Umverdrahtungsleitungen bzw. zu Leiterbahnen präzise strukturiert.

Gemäß dem Verfahren kann auch die Struktur der Leiterbahnen durch unmittelbare Drucktechnik wie einer Siebdrucktechnik erzeugt werden. Dabei wird ein Sieb, das nur an den Stellen, an denen Umverdrahtungsleitungen entstehen sollen, offene Maschen aufweist, verwendet. Diese Siebdrucktechnik ist äußerst preiswert und kann somit die Gesamtkosten der Verfahrens vermindern.

Vor einem Anbringen von Außenkontakten auf den Kontaktflächen, die an Enden der Umverdrahtungsleitungen angeordnet sind, wird selektiv ein Lötstopplack auf die Oberseite des Trägers unter Freilassung der Außenkontaktflächen der Umverdrahtungsleitungen beispielsweise mittels Photolacktechnik aufgebracht. Dieser Lötstopplack deckt die Umverdrahtungsleitungen ab und schützt sie vor einem Benetzen durch die anzubringenden Außenkontakte.

Erfindungsgemäß werden mehrschichtige Leiterbahnstrukturen auf der Oberseite des Trägers aus Kunststoffgehäusemasse aufgebracht. Dazu werden zwischen den Leiterbahnschichten Durchkontakte vorgesehen, um die einzelnen Leiterbahnlagen soweit erforderlich miteinander zu verbinden. Die Herstellung derartiger mehrschichtiger Leiterbahnstrukturen können mit Verfahren der Mikrotechnologie und/oder der Leiterplattentechnologie durchgeführt werden. Dieses hat den Vorteil, daß derartige Technologien erprobt sind und somit preiswerte und erprobte Verfahren zum Einsatz kommen und damit das Herstellungsrisiko minimiert wird.

Zusammenfassend wird mit dem erfindungsgemäßen elektronischen Bauteil und dem Verfahren eine neue Montagetechnik als Technologieplattform für alle möglichen Gehäuseformen möglich. Dabei bleibt die Technologie zur Herstellung verschiedener Gehäuse und Gehäusefamilien immer gleich. Trotzdem ist jedes Pindesign erzeugbar. Hochintegrierte Bauteile in zukünftigen Technologien wie den Fan-Out-Designs sind ebenso herstellbar wie Low-Pin-Count-Anwendungen mit hohen Anforderungen an die Performance bis hin zu Wafe-Level-Packages.

Mit dem erfindungsgemäßen elektronischen Bauteil und dem Verfahren werden aufwendige Umverdrahtungsfunktionen eines Interposers entbehrlich. Kostengünstige Gehäusealternativen für hochintegrierte oder hochpolige Bauformen sind ohne Einsatz von Mehrfachlagensubstraten und eventuell zusätzlichen Interposern möglich. Außerdem haben das elektronische Bauteil und das Verfahren gemäß dieser Erfindung den Vorteil, daß ein Drahtbonden oder ein Flip-Chip-Bonden vollständig entfallen. Somit sind mit der vorliegenden Erfindung sowohl Mehrlagenaufbauten genauso möglich wie Einlagenverdrahtungen. Ferner können beliebige Anschlußmuster hergestellt werden und es besteht technologisch kein Unterschied zwischen unterschiedlichen Gehäusen. Damit sind das erfindungsgemäße Verfahren und die dazu gehörigen Prozesse gehäuseunabhängig.

Die Erfindung wird nun anhand von mehreren Ausführungsbeispielen mit Bezug auf die beiliegenden Zeichnungen näher erläutert.
- Figur 1: zeigt einen schematischen Querschnitt durch ein nicht erfindungsgemäßes Beispiel für ein elektronisches Bauteil,
- Figur 2: zeigt einen schematischen Querschnitt durch ein erstes erfindungsgemäßes elektronisches Bauteil,
- Figur 3: zeigt einen schematischen Querschnitt durch einen Halbleiterwafer mit auf Kontaktflächen aufgebrach- ten Kontaktsäulen,
- Figur 4: zeigt einen schematischen Querschnitt durch mehrere aus dem Halbleiterwafer gemäß Figur 3 hergestellte Halbleiterchips mit auf Kontaktflächen aufgebrach- ten Kontaktsäulen,
- Figur 5: zeigt einen schematischen Querschnitt durch einen Träger aus Kunststoffgehäusemasse mit eingebetteten Halbleiterchips gemäß Figur 4,
- Figur 6: zeigt einen schematischen Querschnitt durch den Träger aus Figur 5, nachdem Umverdrahtungsleitungen auf diesem vorgesehen worden sind,
- Figur 7: zeigt einen schematischen Querschnitt durch den Träger aus Figur 6, nachdem auf dessen Oberseite Außenkontakte aufgebracht worden sind,
- Figur 8: zeigt einen schematischen Querschnitt durch zwei elektronische Bauteile, die nach dem Auftrennen des Trägers aus Figur 7 in Einzelbauteile entstanden sind,
- Figur 9: zeigt einen schematischen Querschnitt durch ein zweites erfindungsgemäßes elektronisches Bauteil,
- Figur 10: zeigt einen schematischen Querschnitt durch einen Halbleiterwafer mit auf Kontaktflächen aufgebrach- ten Kontaktsäulen und mit einer auf dessen Unter- seite aufgebrachten Beschichtung aus einer Kunst- stoffgehäusemasse,
- Figur 11: zeigt einen schematischen Querschnitt durch mehrere Halbleiterchips des Halbleiterwafers aus Figur 10 mit auf Kontaktflächen aufgebrachten Kontaktsäulen, wobei die Halbleiterchips mit ihrer an der Unter- seite vorgesehenen Beschichtung auf einer Formplat- te angeordnet sind,
- Figur 12: zeigt einen schematischen Querschnitt durch einen Träger aus Kunststoffgehäusemasse mit den darin eingebetteten Halbleiterchips aus Figur 11,
- Figur 13: zeigt einen schematischen Querschnitt durch den Träger aus Figur 12, wobei auf dem Träger Umver- drahtungsleitungen und Durchkontakte angeordnet sind,
- Figur 14: zeigt einen schematischen Querschnitt durch den Träger aus Figur 13, wobei auf dessen Oberseite Au- ßenkontakte angebracht sind,
- Figur 15: zeigt einen schematischen Querschnitt durch zwei elektronische Bauteile, die durch Auftrennen des Trägers aus Figur 14 entstanden sind, und
- Figur 16: zeigt einen schematischen Querschnitt durch ein drittes erfindungsgemäßes elektronisches Bauteile.

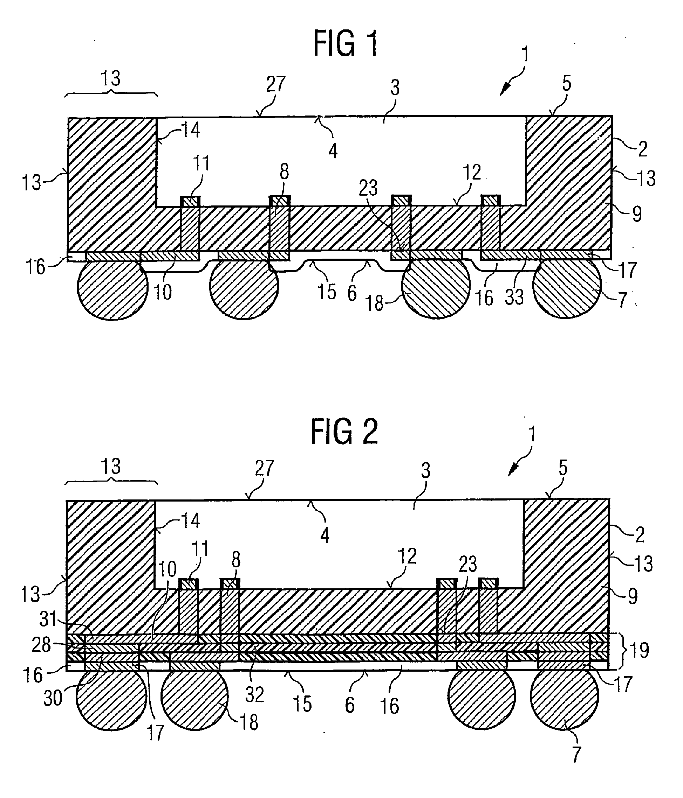

Figur 1 zeigt einen schematischen Querschnitt durch ein elektronisches Bauteil 1. Das elektronische Bauteil 1 gliedert sich in ein Kunststoffgehäuse 2 sowie in einen Halbleiterchip 3, der eine Rückseite 4 und eine aktive Oberseite 12 aufweist. Das Kunststoffgehäuses 2 weist eine Oberseite 5 und eine Unterseite 6 auf. Auf der Unterseite 6 sind Außenkontakte 7 angeordnet. Diese Außenkontakte 7 sind über Umverdrahtungsleitungen 10 in einer Umverdrahtungsebene 33 und über Kontaktsäulen 8 elektrisch mit Kontaktflächen 11 auf der aktiven Oberseite des Halbleiterchips 3 verbunden.

Die Kontaktsäulen 8 sind als metallische Überhöhungen der Kontaktflächen 11 auf der Oberseite 12 des Halbleiterchips 3 ausgebildet. Die Kontaktsäulen 8 weisen eine Länge und damit eine Überhöhung zwischen 5 µm und 150 µm auf. Die Kontaktsäulen 8 sind aus Kupfer, Gold oder Legierungen derselben aufgebaut. Die Umverdrahtungsleitungen 10 liegen bei der ersten Ausführungsform der Erfindung unmittelbar auf der Kunststoffgehäusemasse 9 auf und kontaktieren mit einem Ende die Oberseite 23 einer Kontaktsäule 8. Die Umverdrahtungsleitungen 10 weisen an ihrem anderen Ende eine Außenkontaktfläche 17 auf, auf der jeweils ein Außenkontakt 7 angeordnet ist. Die Mantelflächen der Kontaktsäulen 8 sind vollständig in Kunststoffgehäusemasse eingebettet. Die Seitenflächen des Halbleiterchips und die Oberseite des Halbleiterchip ist in dieser Ausführungsform derart von Kunststoffgehäusemasse 9 umgeben, daß am elektronischen Bauteil 1 Seitenränder 13 aus Kunststoffgehäusemasse 9 ausgebildet sind.

Durch Variation der Breite der Seitenränder 13 können am elektronische Bauteil 1 unabhängig von der Chipgröße des Halbleiterchips 3 beliebig große Außenflächen zum Anordnen von Außenkontaktflächen bzw. zum Anordnen von Außenkontakten 7 vorgesehen werden. In der in Figur 1 gezeigten ersten Ausführungsform der Erfindung ist nur eine einzige Umverdrahtungsebene 33 auf der Unterseite 6 des Kunststoffgehäuses 2 angeordnet. Auf dieser Umverdrahtungsebene ist unter Freilassung der Außenkontaktflächen 17 ein Lötstopplack 16 angebracht, um ein Benetzen der Lötbälle 18 als Außenkontakte 7 auf die Außenkontaktflächen 17 selbst zu begrenzen.

Bei dieser Ausführungsform der Erfindung werden weder Systemträger noch Umverdrahtungsplatten eingesetzt, auch wird auf jegliche Drahtbondverbindung oder Flip-Chip-Kontaktgabe an der Oberseite 12 des Halbleiterchips verzichtet, so daß dieses elektronische Bauteil einen einfachen und kompakten Aufbau aufweist, der äußerst zuverlässige elektrische Verbindungen zwischen makroskopischen Außenkontakten 7 und mikroskopisch kleinen Kontaktflächen 11 schafft. Unter mikroskopisch klein sind dabei Flächen und Abmessungen zu verstehen, die lediglich unter einem Lichtmikroskop meßbar sind, während makroskopische Komponenten mit bloßem Auge erkennbar und mit entsprechenden Messwerkzeugen meßbar sind.

Der Halbleiterchip 3 in den Ausführungsformen der Erfindung hat eine Chipdicke zwischen 100 µm und 750 µm und eine Größe zwischen 2,5 mm und 25 mm Kantenlänge.

Figur 2 zeigt einen schematischen Querschnitt durch ein elektronisches Bauteil 1 gemäß einer ersten Ausführungsform der Erfindung. Komponenten mit gleichen Funktionen wie in Figur 1 werden mit gleichen Bezugszeichen gekennzeichnet und nicht extra erläutert.

Ein Unterschied zwischen dem Beispiel nach Figur 1 und der ersten Ausführungsform nach Figur 2 liegt darin, daß auf der Unterseite 6 des Kunststoffgehäuses der zweiten Ausführungsform nach Figur 2 nicht eine einzige sondern mehrere Umverdrahtungsebenen angeordnet sind. In der zweiten Ausführungsform ist eine äußere Umverdrahtungsebene 30 vorgesehen, die von einem Lötstopplack bis auf die Außenkontaktflächen 17 abgedeckt wird. Außerdem ist eine innere Umverdrahtungsebene 31 vorgesehen, die bis auf den Bereich der Außenkontakte 17 durch eine Isolationsschicht 32 abgedeckt wird. Die Isolationsschicht 32 ist dabei als Polyimidschicht ausgeführt. Durch die Polyimidschicht führen in den Bereichen der Außenkontaktflächen 17 Durchkontakte 28 hindurch, um die Außenkontakte 7 mit der inneren Umverdrahtungsebene 31 zu verbinden.

Je nach Anzahl und Dichte der Kontaktflächen 11 auf der aktiven Oberseite 12 des Halbleiterchips 3 können auch mit der zweiten Ausführungsform nahezu beliebig viele Außenkontakte 7 auf der Unterseite 15 des elektronischen Bauteils 1 angeordnet werden. Nicht nur eine zweilagige Leiterbahnstruktur, wie sie in Figur 2 gezeigt wird, sondern auch mehrschichtige Leiterbahnstrukturen 19 sind auf der Kunststoffgehäusemasse 9 herstellbar.

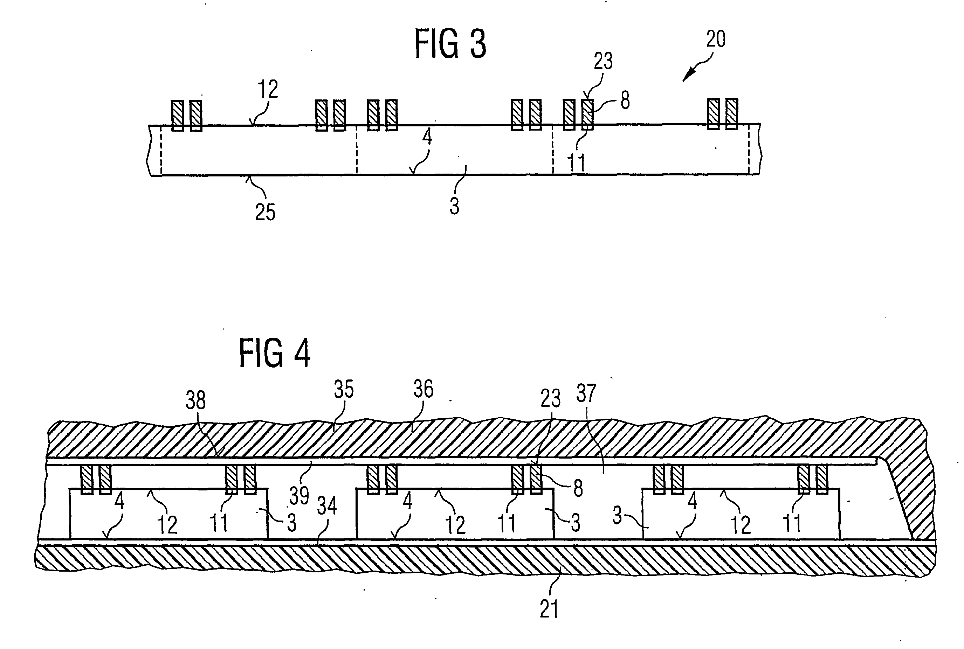

Figur 3 zeigt einen schematischen Querschnitt durch einen Halbleiterwafer 20 mit auf Kontaktflächen 11 aufgebrachten Kontaktsäulen 8 im Rahmen der Herstellung der ersten oder zweiten Ausführungsform der Erfindung. Komponenten mit gleichen Funktionen wie in den vorhergehenden Figuren werden mit gleichen Bezugszeichen gekennzeichnet und nicht extra erläutert. Ausgangspunkt der Herstellung eines elektronischen Bauteils 1, wie es in den Figuren 1 und 2 gezeigt wird, ist ein Halbleiterwafer, der auf seiner Oberseite mehrere integrierte Schaltungen aufweist, die in Zeilen und Spalten zu Halbleiterchips angeordnet sind. Die Elektroden der einzelnen Bauelemente jeder integrierten Schaltung sind mit mikroskopisch kleinen Kontaktflächen auf der Oberseite jedes Halbleiterchips verbunden. Diese Kontaktflächen 11 sind somit auch auf der Oberseite des Halbleiterwafers 20 angeordnet.

Gemäß Figur 3 erfolgt zunächst im Rahmen der Herstellung eines erfindungsgemäßen Bauteils eine säulenförmige Überhöhung der Kontaktflächen 11 zu Kontaktsäulen 8 auf dem Halbleiterwafer 20. Diese säulenförmige Verlängerung erfolgt dadurch, daß zunächst eine dünne Metallfläche auf der Oberseite 12 des Halbleiterwafers 20 abgeschieden wird und anschließend diese Metallschicht von wenigen Mikrometern Dicke mit einer isolierenden Maske versehen wird, die lediglich die Kontaktflächen 11 freiläßt. Anschließend wird der Halbleiterwafer unter Kontaktierung der durchgehenden dünnen Metallschichten in ein galvanisches oder elektrolythisches Bad zur Metallabscheidung der Kontaktsäulen eingetaucht.

Nach Ausbildung der Kontaktsäulen in den Öffnungen der isolierenden Maske wird diese Maske beispielsweise mittels Veraschung in einem Plasmaofen oder mittels Auflösen durch entsprechende Lösungsmittel entfernt. Damit liegen die Kontaktsäulen 8 frei und sind lediglich mit einer dünnen Metallschicht elektrisch verbunden, die durch einen kurzen Ätzvorgang von der Oberfläche der Kunststoffgehäusemasse abgeätzt werden kann. Die Abnahme der Überhöhung der Kontaktsäulen und die gleichzeitige Anätzung des Mantelbereichs der Kontaktsäulen kann dabei in Kauf genommen werden, so daß kein extra Schutz oder eine extra Maske für die Kontaktsäulen bei diesem Ätzvorgang erforderlich ist.

Eine andere, in dieser Ansicht nicht gezeigte Möglichkeit, eine derartige Säulenstruktur auf den Kontaktflächen 11 aufzubauen, besteht durch Metallabscheidung durch eine Maske hindurch. Die Metallabscheidung wird dabei mittels Aufdampftechnik oder Metallaufstäubung wie einem Sputtern durchgeführt. Dabei wird als abzuscheidendes Metall Kupfer, Gold oder Legierungen derselben eingesetzt.

Eine weitere Möglichkeit zur Bildung insbesondere von sehr hohen bzw. langen Säulen beispielsweise über 50 µm besteht in dem Aufbringen von Bondköpfen, vorzugsweise von Thermosonic-Kompressionsköpfen auf die Kontaktflächen. Diese Thermosonic-Kompressionsköpfen bzw. Bondköpfe sind mechanisch äußerst stabil und können bereits auf dem gesamten Wafer für sämtliche Halbleiterchips aufgebracht werden.

Figur 4 zeigt einen schematischen Querschnitt durch mehrere Halbleiterchips 3 mit auf Kontaktflächen 11 aufgebrachten Kontaktsäulen 8, die auf einer Formplatte 21 angeordnet sind. Komponenten mit gleichen Funktionen wie in den vorhergehenden Figuren werden mit gleichen Bezugszeichen gekennzeichnet und nicht extra erläutert.

Die Formplatte 21 ist zur Aufnahme der Halbleiterchips 3 mit einer doppelseitig klebenden Folie 34 versehen. Die Formplatte 21 bildet gleichzeitig einen Teil einer zweigeteilten Spritzgußform. Das zweite Formteil 36 wird nach Anordnen der Halbleiterchips 3 auf der Formplatte 21 aufgebracht, wobei das zweite Formteil 36 auf der oberen inneren Wandung 38 seiner Formkavität 37 eine Dichtfolie 39 aufweist, in die sich die Kontaktsäulen 8 mit ihren Oberseiten 23 einarbeiten können. Mit dieser Dichtfolie 39 werden gleichzeitig Höhentoleranzen der Kontaktsäulen 8 untereinander ausgeglichen.

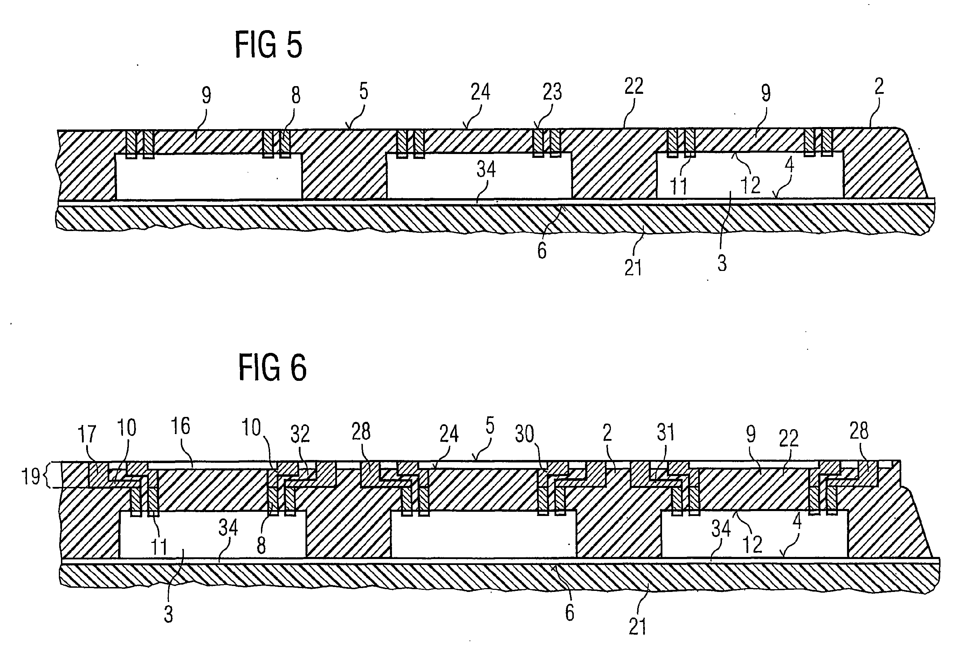

Figur 5 zeigt einen schematischen Querschnitt durch einen Träger 22 aus Kunststoffgehäusemasse 9 mit eingebetteten Halbleiterchips 3. Komponenten mit gleichen Funktionen wie in den vorhergehenden Figuren werden mit gleichen Bezugszeichen gekennzeichnet und nicht extra erläutert.

Der Träger 22 aus Kunststoffgehäusemasse 9 ist durch Ausgießen der Formkavität 37 einer Spritzgußform 35 hergestellt, wie es in Figur 4 gezeigt wird. Dabei sind an der Oberseite 24 des Trägers 22 die Oberseiten 23 der Kontaktsäulen 8 frei zugänglich. Auf der Oberseite 24 des Trägers 22 können nun eine einzelne Umverdrahtungsebene, wie sie für das Beispiel gemäß Figur 1 vorgesehen ist, oder, erfindungsgemäß, eine mehrschichtige Leiterbahnstruktur, wie sie für die erste Ausführungsform der Erfindung gemäß Figur 2 vorgesehen ist, angeordnet werden. Dabei kann die Formplatte 21 den Träger 22 stützen. Der Träger 22 ist selbsttragend, so daß die Formplatte 21 noch vor dem Aufbringen von Umverdrahtungsebenen entfernt werden kann. Der Träger 22 aus Kunststoffgehäusemasse 9 weist in Zeilen und Spalten angeordnete Bauteilpositionen mit jeweils einem eingebetteten Halbleiterchip 3 und dazugehörigen Kontaktsäulen 8 auf.

Figur 6 zeigt einen schematischen Querschnitt durch einen Träger 22 aus Kunststoffgehäusemasse 9 mit auf dem Träger 22 angeordneten Umverdrahtungsleitungen 10 und Durchkontakten 28. Komponenten mit gleichen Funktionen wie in den vorhergehenden Figuren werden mit gleichen Bezugszeichen gekennzeichnet und nicht extra erläutert.

Die Umverdrahtungsleitungen in Figur 6 sind in zwei Ebenen angeordnet, nämlich in einer inneren Umverdrahtungsebene 31 und in einer äußeren Umverdrahtungsebene 30. Zwischen den Umverdrahtungsebenen 30 und 31 ist eine Isolationsschicht 32 angeordnet. Die äußere Umverdrahtungsebene 30 wird von einer Lötstopplackschicht 16 abgedeckt, die lediglich die Außenkontaktflächen 17 freiläßt. Auf den Außenkontaktflächen 17 können so gleichzeitig für mehrere elektronische Bauteile Außenkontakte (7) angebracht werden.

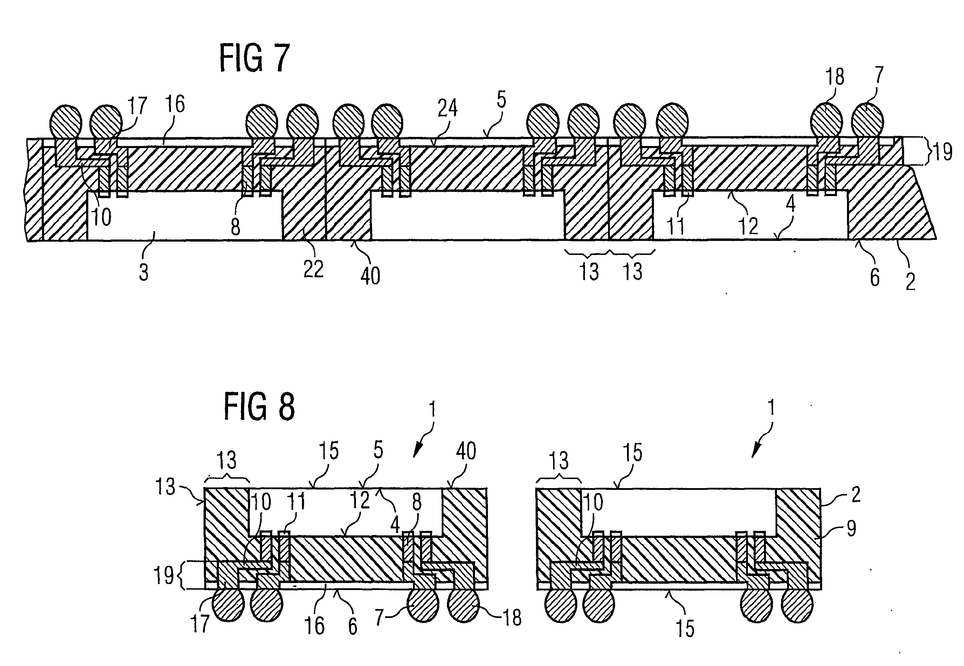

Figur 7 zeigt einen schematischen Querschnitt durch einen Träger 22 aus Kunststoffgehäusemasse 9 mit auf der Oberseite 24 des Trägers 22 aufgebrachten Außenkontakten 7. Komponenten mit gleichen Funktionen wie in den vorhergehenden Figuren werden mit gleichen Bezugszeichen gekennzeichnet und nicht extra erläutert.

Der selbsttragende Träger 22 ist in Figur 7 von seiner Formplatte 21 und Klebstoffolie 34 befreit, wie sie in den Figuren 4 bis 6 dargestellt werden. Während die Oberseite 24 des Trägers 22 in Figur 7 bereits Lötbälle 18 als Außenkontakte 7 aufweist, wechseln sich an der Unterseite 40 des Trägers 22 Bereiche mit Kunststoffgehäusemasse 9 und Bereiche mit den Rückseiten 4 der Halbleiterchips 3 ab. Die Halbleiterchips 3 sind hier in Zeilen und Spalten angeordnet, so daß der Träger 22 ohne großen Aufwand zu elektronischen Bauteilen getrennt werden kann.

Figur 8 zeigt einen schematischen Querschnitt durch zwei elektronische Bauteile 1 nach dem Auftrennen des Trägers 22 aus Kunststoffgehäusemasse 9 in Einzelbauteile gemäß Figur 2. Komponenten mit gleichen Funktionen wie in den vorhergehenden Figuren werden mit gleichen Bezugszeichen gekennzeichnet und nicht extra erläutert.

Durch einen Trennschritt, beispielsweise durch Sägen, Laserverdampfen oder Trockenätzen, wird der in Figur 7 gezeigte Träger 22 in die in Figur 8 gezeigten Einzelbauteile aufgetrennt. Bei Verwendung glatter Sägeblätter entstehen die gezeigten rechtwinkligen Kunststoffgehäuseformen.

Anstelle solcher rechtwinkliger Kunststoffgehäuseformen mit entsprechend steilen Seitenrändern der elektronischen Bauteile 1 können durch Profilsägen in einem hier nicht gezeigten Ausführungsbeispiel auch beliebige Konturen des Seitenrandes 13 hergestellt werden. Je nach Anzahl der erforderlichen Außenkontakte 7 können die Seitenränder auch breiter oder schmaler dargestellt werden, als es in Figur 8 dargestellt ist. Somit ist eine große Variationsbreite für die Gestaltung der Gehäuseform gegeben. Auch die Anzahl der Außenkontakte 7 kann beliebig erhöht werden. Somit lassen sich die unterschiedlichsten Anforderungen an die Gehäusestruktur eines elektronischen Bauteils 1 erfüllen.

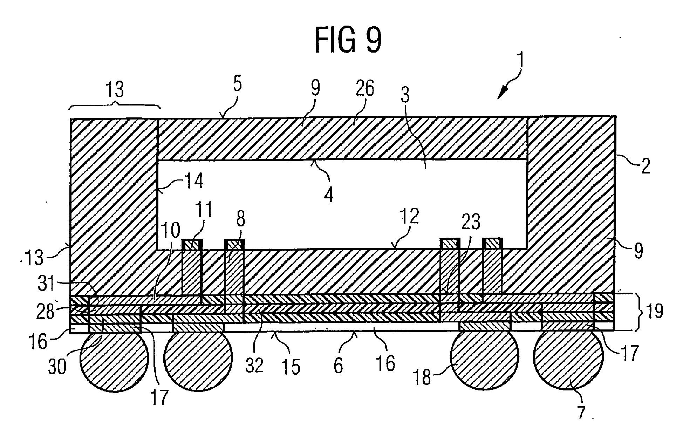

Figur 9 zeigt einen schematischen Querschnitt durch ein elektronisches Bauteil 1 gemäß einer zweiten Ausführungsform der Erfindung. Komponenten mit gleichen Funktionen wie in den vorhergehenden Figuren werden mit gleichen Bezugszeichen gekennzeichnet und nicht extra erläutert.

In der ersten Ausführungsform der Erfindung gemäß Figur 2 bildet die Rückseite 4 des Halbleiterchips 3 eine Außenkontaktfläche an der Oberseite 5 des elektronischen Bauteils 1. Anders als dort ist die Rückseite 4 des Halbleiterchips 3 der zweiten Ausführungsform gemäß Figur 9 durch eine Beschichtung 26 aus Kunststoffgehäusemasse 9 geschützt. Auf der Unterseite des elektronischen Bauteils 1 der zweiten Ausführungsform gemäß Figur 9 ist wie bei der ersten Ausführungsform eine mehrschichtige Leiterbahnstruktur 19 angeordnet.

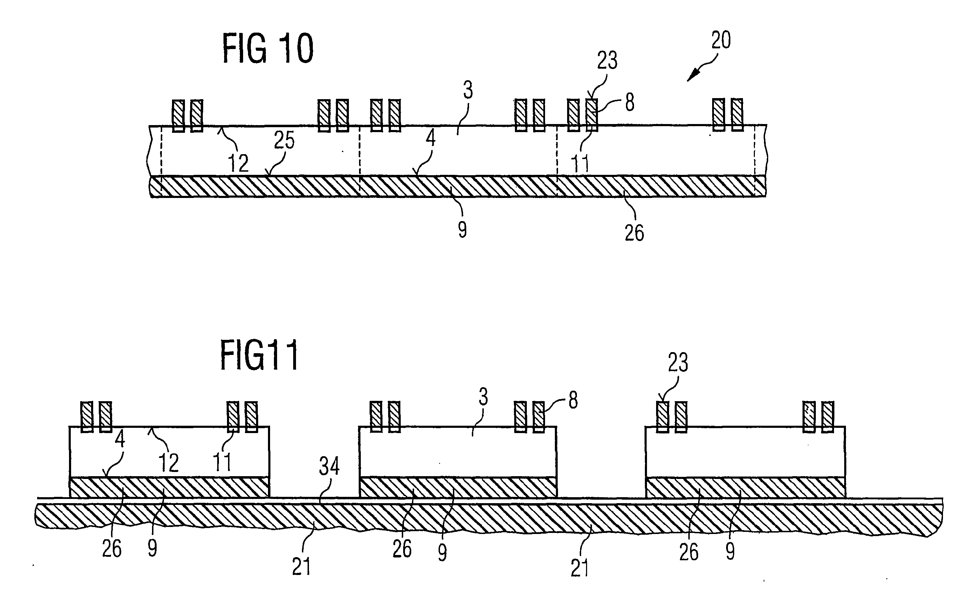

Figur 10 zeigt einen schematischen Querschnitt durch einen Halbleiterwafer 20 mit auf Kontaktflächen 11 aufgebrachten Kontaktsäulen 8 und mit auf der Unterseite des Halbleiterwafers 20 aufgebrachten Beschichtungen 26 aus Kunststoffgehäusemasse 9 im Rahmen der Herstellung der zweiten Ausführungsform der Erfindung. Komponenten mit gleichen Funktionen wie in den vorhergehenden Figuren werden mit gleichen Bezugszeichen gekennzeichnet und nicht extra erläutert.

Um die Rückseite 4 der Halbleiterchips 3 zu schützen, wird nach dem Aufbringen der Kontaktsäulen 8 auf den Kontaktflächen 11 an der Oberseite des Halbleiterwafers 20 dessen Unterseite 25 mit einer Kunststoffgehäuseschicht 26 beschichtet. Diese Beschichtung kann durch Dispension oder durch einen Spritzgußvorgang auf die gesamte Rückseite des Halbleiterwafers 20 aufgebracht werden. Damit wird gleichzeitig für viele elektronische Bauteile 1 des Halbleiterwafers 20 die Rückseite der Halbleiterchips 3 durch eine Beschichtung 26 aus Kunststoffgehäusemasse 9 geschützt.

Figur 11 zeigt einen schematischen Querschnitt durch mehrere Halbleiterchips 3 mit auf Kontaktflächen 11 aufgebrachten Kontaktsäulen 8, die mit ihren Beschichtungen 26 aus Kunststoffgehäusemasse 9 der jeweiligen Unterseite auf einer Formplatte 21 im Rahmen der Herstellung der dritten Ausführungsform der Erfindung angeordnet sind. Komponenten mit gleichen Funktionen wie in den vorhergehenden Figuren werden mit gleichen Bezugszeichen gekennzeichnet und nicht extra erläutert.

Die Formplatte 21 weist zur Aufnahme der Halbleiterchips 3 in dieser Ausführungsform der Erfindung eine doppelseitig klebende Folie 34 auf, mit der die Positionen der Halbleiterchips 3 mit ihrer Beschichtung 26 aus Kunststoffgehäusemasse 9 fixiert werden. Anschließend wird auf die Formplatte 21 ein hier nicht dargestelltes Formstück mit einer Kavität aufgebracht, dessen obere Wandung eine Dichtfolie aufweist. In diese Dichtfolie können sich die Oberseiten 23 der Kontaktsäulen 28 einarbeiten. Danach wird die Kavität mit einer Kunststoffgehäusemasse aufgefüllt und das Formwerkzeug abgenommen.

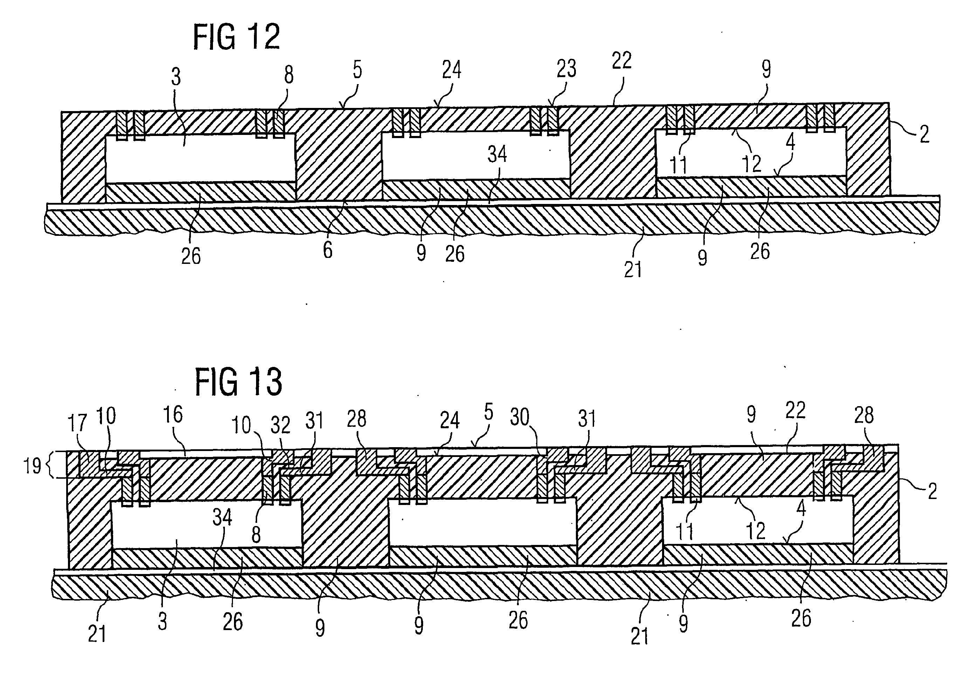

Figur 12 veranschaulicht diesen Zustand. Danach liegt auf der Formplatte 21 ein Träger 22 aus Kunststoffgehäusemasse vor. Dabei verbindet sich die aufgebrachte Kunststoffgehäusemasse mit der Beschichtung aus Kunststoffgehäusemasse 9 zu einer Einheit, so daß die Halbleiterchips 3 vollständig in Kunststoffgehäusemasse 9 eingebettet sind.

Figur 12 zeigt einen schematischen Querschnitt durch einen Träger 22 aus Kunststoffgehäusemasse 9 mit eingebetteten Halbleiterchips 3 im Rahmen der Herstellung der dritten Ausführungsform der Erfindung. Komponenten mit gleichen Funktionen wie in den vorhergehenden Figuren werden mit gleichen Bezugszeichen gekennzeichnet und nicht extra erläutert.

In Figur 12 ist der Träger 22 aus Kunststoffgehäusemasse 9 noch auf der Formplatte 21 angeordnet. Der Träger 22 ist dabei selbsttragend ausgebildet, so daß er jederzeit von der Formplatte 21 abgenommen werden kann. Auf der Oberseite 24 des Trägers 22 sind die Oberseiten 23 der Kontaktsäulen 8 frei zugänglich, so daß auf diesen mikroskopisch kleinen Flächen 23 Umverdrahtungsleitungen angebracht werden können, um makroskopisch große Außenkontaktflächen zu bilden.

Figur 13 zeigt einen schematische Querschnitt durch den Träger 22 aus Figur 12 mit auf dem Träger 22 angeordneten Umverdrahtungsleitungen 10 und Durchkontakten 28.

Bei der zweiten Ausführungsform der Erfindung wird eine mehrschichtige Leiterbahnstruktur 19 auf die Oberseite 24 des Trägers 22 aufgebracht. Dazu wird zunächst eine innere Umverdrahtungsebene 31 aufgebracht, indem Kupfer, Gold, Silber oder Legierungen derselben auf der Oberseite 24 des Trägers 22 abgeschieden werden und anschließend strukturiert werden. Danach wird unter Freilassen von Durchgangsöffnungen eine Isolationsschicht 32 auf der strukturierten inneren Umverdrahtungsebene 31 abgeschieden oder aufgebracht und anschließend werden die Durchgangsöffnungen metallisiert, so daß Durchkontakte 28 entstehen, die durch die Isolationsschicht 32 hindurchführen. Schließlich wird auf der Isolationsschicht 32 die äußere Umverdrahtungsebene 30 aufgebracht, die aus den gleichen Materialien bestehen kann, wie die innere Umverdrahtungsebene. Schließlich wird die äußere Umverdrahtungsebene 30 von einem Lötstopplack unter Freilassung von Außenkontaktflächen 17 abgedeckt, damit Material der aufzubringenden Außenkontakte 7 nicht die Umverdrahtungsleitungen 10 benetzt.

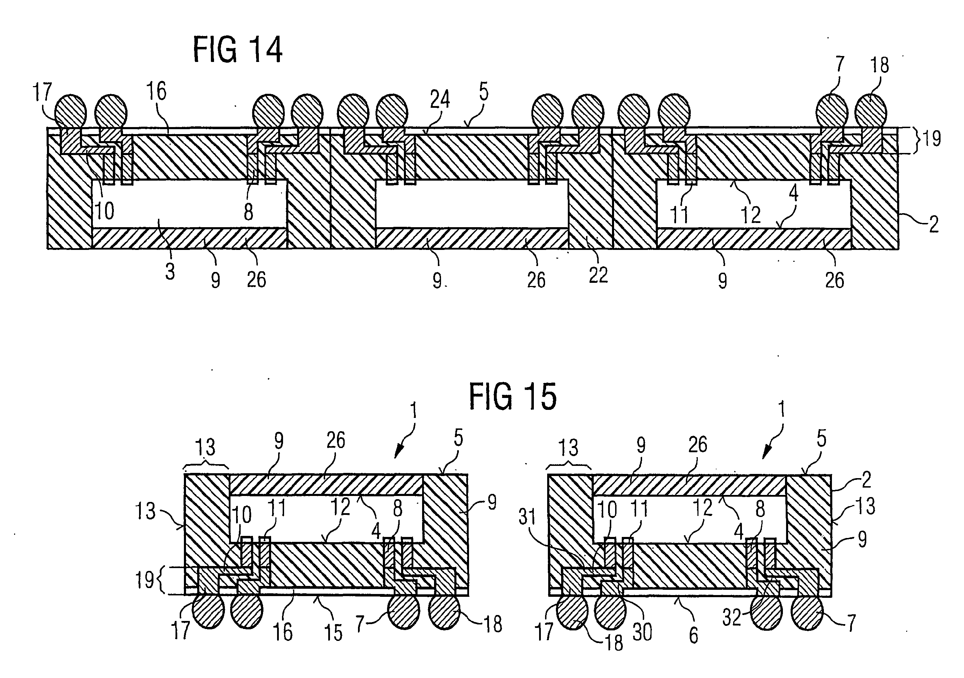

Figur 14 zeigt einen schematischen Querschnitt durch den Träger 22 aus Figur 13 mit auf der Oberseite 24 des Trägers 22 aufgebrachten Außenkontakten 7.

Auf die Außenkontaktflächen 17 auf der Oberseite des Trägers 22 werden in dieser zweiten Ausführungsform der Erfindung in ähnlicher Weise wie in der ersten Ausführungsform der Erfindung Lötbälle 18 aufgebracht, um Außenkontakte 7 herzustellen. Mit dem Aufbringen der Lötbälle 18 auf dem gesamten Träger sind sämtliche elektronischen Bauteile 1 hergestellt und werden in einem weiteren Schritt in Einzelbauteile getrennt. Dabei ist die Rückseite jedes Halbleiterchips 3 im Gegensatz zu den vorhergehenden Ausführungsformen nun mit einer Kunststoffgehäusemasse 9 beschichtet. Diese Beschichtung 26 kann, wie in Figur 10 gezeigt, für alle Halbleiterchips 3 auf einmal auf die Unterseite eines Halbleiterwafers 20 aufgebracht werden.

Figur 15 zeigt einen schematischen Querschnitt durch zwei elektronische Bauteile 1 nach dem Auftrennen des Trägers 22 aus Figur 14 in Einzelbauteile.

Nach dem Auftrennen des Trägers 22 aus Figur 14 in einzelne elektronische Bauteile 1, wie sie in Figur 15 zu sehen sind, steht ein Gehäuse zur Verfügung, das den Halbleiterchip 3 vollständig einbettet. Gleichzeitig wird damit ein elektronisches Bauteil 1 realisiert, das keine Bonddrähte und auch keine Kontakthöcker wie bei der Flip-Chip-Technologie auf der Oberseite des Halbleiterchips 3 aufweist. Die gesamte Verbindungstechnologie wird damit zuverlässiger und weniger anfällig gegenüber Vibrationen und anderen Belastungen des elektronischen Bauteils 1.

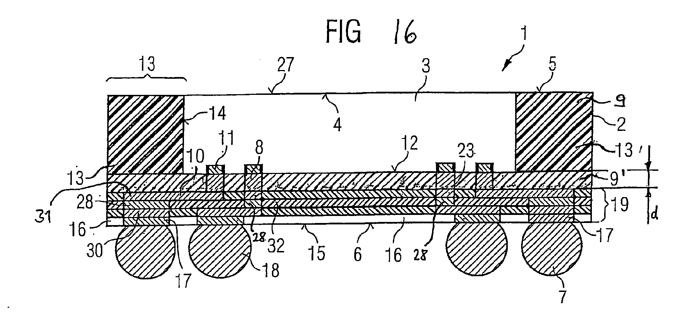

Figur 16 zeigt einen schematischen Querschnitt durch ein drittes erfindungsgemäßes elektronisches Bauteil 1 mit einem Kunststoffgehäuse 2, das eine Kunststoffmasse 9 und eine Kunststoffschicht 9' aufweist. Komponenten mit gleichen Funktionen wie in den vorhergehenden Figuren werden mit gleichen Bezugszeichen gekennzeichnet und nicht extra erläutert.

Die Kunststoffmasse 9 umgibt die Seitenränder 14 des Halbleiterchips 3 und bildet Seitenränder 13 aus, die beliebig größer als die Seitenränder 14 des Halbleiterchips 3 gestaltet sein können. Die elektrisch isolierende Kunststoffschicht 9' ist auf der aktiven Oberseite 12 des Halbleiterchips 3 und auf den Seitenrändern 13 aus Kunststoffmasse 9 angeordnet und überbrückt den Übergangsbereich zwischen den Seitenrändern 13 und dem Halbleiterchip 3 . Die Kontaktflächen 11 des Halbleiterchips 3 sind nicht mit der Kunststoffschicht 9' bedeckt.

Die Kunststoffschicht 9' trägt eine erste Umverdrahtungsebene 30 und eine zweite Umverdrahtungsebene 31, welche über als Kontaktsäulen 8 ausgebildete Durchkontakte 28 mit den Kontaktflächen 11 des Halbleiterchips 3 elektrisch verbunden sind. Die Kontaktsäulen 8 und/oder die Durchkontakte 28 können zusammen mit der Umverdrahtungsebene 30 galvanisch oder chemisch abgeschiedenes Metall aufweisen.

Die Kunststoffschicht 9' weist eine Dicke d auf, die kleiner oder gleich 30 µm ist. In einem hier nicht gezeigten Ausführungsbeispiel ist die Dicke d kleiner oder gleich 20 µm, was beispielsweise mit einem Schleifvorgang ausgeführt werden kann, der eine sehr ebene Oberfläche erzeugt. Dabei kann die erste Umverdrahtungsebene 30 auch unmittelbar auf einer als Kunststoffschicht 9' ausgebildeten obersten Passivierungsschicht des Halbleiterchips 3 angeordnet sein, womit die Dikke d der Kunststoffschicht 9' sehr klein, nahezu 0 oder sogar gleich 0 wird, d.h. es ist dann außer der Passivierungsschicht keine weitere Isolationsschicht mehr vorhanden. Oberhalb der ersten Umverdrahtungsebene 30 und der zweiten Umverdrahtungsebene 31 können noch weitere Umverdrahtungsebenen vorgesehen sein.

## Patentansprüche

1. Elektronisches Bauteil, das die folgenden Merkmale aufweist:
- ein Kunststoffgehäuse (2), in dem ein Halbleiterchip (3) angeordnet ist, wobei das Kunststoffgehäuse (2) Seitenränder (13) aufweist, die um Seitenränder (14) des Halbleiterchips (3) herum angeordnet sind,
- auf der aktiven Oberseite (12) des Halbleiterchips (3) und auf den neben der aktiven Oberseite (12) des Halbleiterchips (3) angeordneten Seitenrändern (13) des Kunststoffgehäuses (2) ist eine elektrisch isolierende Kunststoffschicht (9; 9') mit einer Dicke (d) von bis zu 30µm, insbesondere von bis zu 20µm ausgebildet,
- an einer Unterseite (6) des elektronischen Bauteils sind Außenkontakte (7) vorgesehen,
- die Außenkontakte (7) sind über in wenigstens zwei Umverdrahtungsebenen (31, 32) angeordneten Umverdrahtungsleitungen (10) und über Kontaktsäulen (8) mit Kontaktflächen (11) auf der aktiven Oberseite (12) des Halbleiterchips (3) verbunden,
- es ist eine mehrschichtige Leiterbahnstruktur (19) zur Umverdrahtung von den Kontaktsäulen (8) zu den Außenkontakten (7) vorgesehen, und
- die Unterseite (15) des elektronischen Bauteils (1) weist eine Lötstoppschicht (16) unter Freibleiben von Außenkontaktflächen (17) der Außenkontakte (7) auf.

2. Elektronisches Bauteil nach Anspruch 1,
**dadurch gekennzeichnet, daß**
zwischen der Kunststoffschicht (9; 9') und der Umverdrahtungsebene bzw. einer der Umverdrahtungsebenen (31, 32) wenigstens eine weitere elektrisch isolierende Zwischenschicht vorgesehen ist.

3. Elektronisches Bauteil nach Anspruch 1 oder Anspruch 2,
**dadurch gekennzeichnet, daß**
Außenkontakte (7) in Bereichen unterhalb der Seitenränder (13) des Kunststoffgehäuses (2) angeordnet sind.

4. Elektronisches Bauteil nach einem der vorhergehenden Ansprüche,
**dadurch gekennzeichnet, daß**
die Rückseite (4) des Halbleiterchips (3) unterhalb der Oberseite (5) des Kunststoffgehäuses (2) angeordnet ist und von einer Beschichtung (26) aus Kunststoffgehäusemasse (9) bedeckt ist.

5. Elektronisches Bauteil nach einem der vorhergehenden Ansprüche,
**dadurch gekennzeichnet, daß**
die Außenkontakte (7) Lotbälle (18) oder Lothöcker aufweisen

6. Verfahren zur Herstellung eines elektronischen Bauteils (1) mit einem Kunststoffgehäuse (2), in dem ein Halbleiterchip (3) angeordnet ist, wobei das Verfahren folgende Verfahrensschritte aufweist:
- Bereitstellen eines Halbleiterwafers (20) mit in Zeilen und Spalten angeordneten Halbleiterchips (3) mit Kontaktflächen (11),
- säulenförmiges Überhöhen der Kontaktflächen (11) zu Kontaktsäulen (8) auf dem Halbleiterwafer (20),
- Trennen des Halbleiterwafers (20) in einzelne Halbleiterchips (3) mit Kontaktsäulen (8) auf den Kontaktflächen (11),
- Bestücken einer Formplatte (21) mit den Halbleiterchips (3),
- Herstellen eines gemeinsamen Trägers (22) aus Kunststoffgehäusemasse (9) auf der Formplatte (21) für die Halbleiterchips (3), wobei die Halbleiterchips (3) derart in die Kunststoffgehäusemasse (9) eingebettet werden, daß die den Kontaktflächen (11) gegenüberliegenden Oberseiten (23) der Kontaktsäulen (8) freibleibend auf der Oberseite (23) des Trägers (22) angeordnet sind,
- selektives Aufbringen von Umverdrahtungsleitungen (10) auf dem gemeinsamen Träger (22), wobei jeweils ein Leitungsende einer Umverdrahtungsleitung (10) mit einer freiliegenden Oberseite (23) einer Kontaktsäule (8) verbunden wird und das andere Leitungsende eine Außenkontaktfläche (17) führt,
- Aufbringen mehrschichtiger Leiterbahnstrukturen (19) auf der Oberseite (24) des gemeinsamen Trägers (22) zur Herstellung der Umverdrahtungsleitungen (10) von den Kontaktsäulen (8) zu den Außenkontakten (7) an der Oberseite der elektronischen Bauteile (1),
- selektives Aufbringen eines Lötstopplackes (16) auf die Oberseite (24) des Trägers (22) unter Freilassung der Außenkontaktflächen (17) der Umverdrahtungsleitungen (10),
- Aufbringen von Lotbällen (18) oder Lothöckern auf die Außenkontaktflächen (17),
- Trennen des Trägers (22) in einzelne elektronische Bauteile (1).

7. Verfahren nach Anspruch 6,
**dadurch gekennzeichnet, daß**
die Unterseite (25) des Halbleiterwafers (20) vor dem Trennen in Halbleiterchips (3) mit einer Beschichtung (26) aus Kunststoffgehäusemasse (9) versehen wird.

8. Verfahren nach Anspruch 6 oder Anspruch 7,
**dadurch gekennzeichnet, daß**
das säulenförmige Überhöhen der Kontaktflächen (11) zu Kontaktsäulen (8) auf dem Halbleiterchip (3) mittels Metallabscheidung durch eine Maske erfolgt.

9. Verfahren nach Anspruch 6 oder Anspruch 7,
**dadurch gekennzeichnet, daß**
das säulenförmige Überhöhen der Kontaktflächen (11) zu Kontaktsäulen (8) auf dem Halbleiterchip (3) mittels selektiver elektrolytischer Metallabscheidung durch eine Maske erfolgt.

10. Verfahren nach Anspruch 6 oder Anspruch 7,
**dadurch gekennzeichnet, daß**
das säulenförmige Überhöhen der Kontaktflächen (11) zu Kontaktsäulen (8) auf dem Halbleiterchip (3) mittels Drucktechnik erfolgt.

11. Verfahren nach Anspruch 6 oder Anspruch 7,
**dadurch gekennzeichnet, daß**
das säulenförmige Überhöhen der Kontaktflächen (11)zu Kontaktsäulen (8) auf dem Halbleiterchip (3) mittels Metallaufstäubung durch eine Maske erfolgt.

12. Verfahren nach Anspruch 6 oder Anspruch 7,
**dadurch gekennzeichnet, daß**
das säulenförmige Überhöhen der Kontaktflächen (11) zu Kontaktsäulen (8) auf dem Halbleiterchip (3) mittels Aufdampftechnik und anschließender selektiver Ätztechnik des aufgedampften Metalls erfolgt.

13. Verfahren nach Anspruch 6 oder Anspruch 7,
**dadurch gekennzeichnet, daß**
das säulenförmige Überhöhen der Kontaktflächen (11) zu Kontaktsäulen (8) auf dem Halbleiterchip (3) mittels Aufbringen von Bondköpfen vorzugsweise von Thermosonikkompressionsköpfen auf die Kontaktflächen erfolgt.

14. Verfahren nach einem der Ansprüche 6 bis 13,
**dadurch gekennzeichnet, daß**
das Herstellen eines gemeinsamen Trägers (22) aus Kunststoffgehäusemasse (9) für die Halbleiterchips (3) auf der Formplatte (21) durch Spritzgusstechnik mit Hilfe eines Formwerkzeugs erfolgt.

15. Verfahren nach einem der Ansprüche 6 bis 14,
**dadurch gekennzeichnet, daß**
das Herstellen eines gemeinsamen Trägers (22) aus Kunststoffgehäusemasse (9) für die Halbleiterchips (3) auf der Formplatte (21) durch Schleudergusstechnik erfolgt.

16. Verfahren nach einem der Ansprüche 6 bis 15,
**dadurch gekennzeichnet, daß**
das selektive Aufbringen von Umverdrahtungsleitungen (10) auf den gemeinsamen Träger (22) aus Kunststoffgehäusemasse (9) durch Aufbringen einer geschlossenen Metallschicht und anschließender Strukturierung der Metallschicht mittels Photolacktechnik erfolgt.

17. Verfahren nach einem der Ansprüche 6 bis 15,
**dadurch gekennzeichnet, daß**
das selektive Aufbringen von Umverdrahtungsleitungen (10) auf den gemeinsamen Träger (22) aus Kunststoffgehäusemasse (9) durch Drucktechnik insbesondere durch Siebdrucktechnik erfolgt.

18. Verfahren nach einem der Ansprüche 6 bis 17,
**dadurch gekennzeichnet, daß**
das selektive Aufbringen eines Lötstopplackes (16) auf die Oberseite (24) des Trägers (22) unter Freilassung der Außenkontaktflächen (17) der Umverdrahtungsleitungen (10) mittels Photolacktechnik erfolgt.

19. Verfahren nach Anspruch 6,
**dadurch gekennzeichnet, daß**
zur Herstellung mehrschichtiger Leiterbahnstrukturen (19) Verfahren der Mikrotechnologie und/oder der Leiterplattetechnologie eingesetzt werden.

## Claims

1. An electronic component, which has the following features:
- a plastic package (2), in which a semiconductor chip (3) is arranged, the plastic package (2) having side edges (13), which are arranged around side edges (14) of the semiconductor chip (3),
- on the active upper side (12) of the semiconductor chip (3) and on the side edges (13) of the plastic package (2) an electrically insulating layer of plastic (9; 9') with a thickness (d) of up to about 30 µm, and preferably of up to 20 µm is formed,
- provided on an underside (6) of the electronic component are external contacts (7),
- the external contacts (7) are connected to contact areas (11) on an active upper side (12) of the semiconductor chip (3) by means of wiring lines (10) arranged in at least two wiring planes (31, 32) and by means of contact pillars (8)
- a multi-layer interconnect structure (199 for the wiring of the contact pillars (8) to the external contacts (7) is provided, and the underside (15) of the electronic component (1) has a solder resist layer (16), with external contact areas (17) of the external contacts (7) remaining free.

2. The electronic component as claimed in claim 1, **characterized in that** between the layer of plastic (9; 9') and the wiring plane or one of the wiring planes (31, 32) at least one further electrically insulating intermediate layer is provided.

3. The electronic component as claimed in claim 1 or claim 2, **characterized in that** external contacts (7) are arranged in regions underneath the side edges (13) of the plastic package (2).

4. The electronic component as claimed in one of the preceding claims, **characterized in that** the rear side (4) of the semiconductor chip (3) is arranged under the upper side (5) of the plastic package (2) and is covered by a coating (26) of plastic package molding compound (9).

5. The electronic component as claimed in one of the preceding claims, **characterized in that** the external contacts (7) comprise solder balls (18) or solder bumps.

6. A method for producing an electronic component (1) with a plastic package (2), in which a semiconductor chip (3) is arranged, the method having the following method steps:
- providing a semiconductor wafer (20) which has semiconductor chips (3), with contact areas (11), arranged in rows and columns,
- elevating the contact areas (11) in the form of pillars to form contact pillars (8) on the semiconductor wafer (20),
- separating the semiconductor wafer (20) into individual semiconductor chips (3), with contact pillars (8) on the contact areas (11),
- loading a mold plate (21) with the semiconductor chips (3),
- producing a common carrier (22) from plastic package molding compound (9) on the mold plate (21) for the semiconductor chips (3), the semiconductor chips (3) being embedded into the plastic package molding compound (9) in such a way that the upper sides (23) of the contact pillars (8) lying opposite from the contact areas (11) are arranged such that they remain free on the upper side (23) of the carrier (22),
- selectively applying wiring lines (10) on the common carrier (22), one line end of a wiring line (10) in each case being connected to an exposed upper side (23) of a contact pillar (8) and the other line end leading to an external contact area (17),
- application of multi-layered interconnect structures (19) on the upper side (24) of the common carrier (22) to produce the wiring lines (10) from the contact pillars (8) to the external contacts (7) on the upper side of the electronic components (1),
- selectively applying a solder resist (16) to the upper side (24) of the carrier (22), leaving the external contact areas (17) of the wiring lines (10) free,
- applying solder balls (18) or solder bumps to the external contact areas (17),
- separating the carrier (22) into individual electronic components (1).

7. The method as claimed in claim 6, **characterized in that** the underside (25) of the semiconductor wafer (20) is provided with a coating (26) of plastic package molding compound (9) before the separation into semiconductor chips (3).

8. The method as claimed in claim 6 or claim 7, **characterized in that** the elevation of the contact areas (11) in the form of pillars to form contact pillars (8) on the semiconductor chip (3) takes place by means of metal deposition through a mask.

9. The method as claimed in claim 6 or claim 7, **characterized in that** the elevation of the contact areas (11) in the form of pillars to form contact pillars (8) on the semiconductor chip (3) takes place by means of selective electrolytic metal deposition through a mask.

10. The method as claimed in claim 6 or claim 7, **characterized in that** the elevation of the contact areas (11) in the form of pillars to form contact pillars (8) on the semiconductor chip (3) takes place by means of a printing technique.

11. The method as claimed in claim 6 or claim 7, **characterized in that** the elevation of the contact areas (11) in the form of pillars to form contact pillars (8) on the semiconductor chip (3) takes place by means of metal sputtering through a mask.

12. The method as claimed in claim 6 or claim 7, **characterized in that** the elevation of the contact areas (11) in the form of pillars to form contact pillars (8) on the semiconductor chip (3) takes place by means of a vapor-depositing technique and subsequent selective technique of etching the vapor-deposited metal.

13. The method as claimed in claim 6 or claim 7, **characterized in that** the elevation of the contact areas (11) in the form of pillars to form contact pillars (8) on the semiconductor chip (3) takes place by means of applying bonding heads, preferably thermosonic compression heads, to the contact areas.

14. The method as claimed in one of claims 6 to 13, **characterized in that** the production of a common carrier (22) from plastic package molding compound (9) for the semiconductor chips (3) on the mold plate (21) takes place by an injection-molding technique with the aid of a mold.

15. The method as claimed in one of claims 6 to 14, **characterized in that** the production of a common carrier (22) from plastic package molding compound (9) for the semiconductor chips (3) on the mold plate (21) takes place by a centrifugal casting technique.

16. The method as claimed in one of claims 6 to 15, **characterized in that** the selective application of wiring lines (10) to the common carrier (22) of plastic package molding compound (9) takes place by applying a closed metal layer and subsequent structuring of the metal layer by means of a photoresist technique.

17. The method as claimed in one of claims 6 to 15, **characterized in that** the selective application of wiring lines (10) to the common carrier (22) of plastic package molding compound (9) takes place by a printing technique, in particular by a screen printing technique.

18. The method as claimed in one of claims 6 to 17, **characterized in that** the selective application of a solder resist (16) to the upper side (24) of the carrier (22), while leaving the external contact areas (17) of the wiring lines (10) free, takes place by means of a photoresist technique.

19. The method as claimed in claim 6, **characterized in that**, for producing multi-layered interconnect structures (19), methods of microtechnology and/or printed circuit board technology are used.

## Revendications

1. Composant électronique présentant les caractéristiques suivantes :
- un boîtier en plastique (2), dans lequel est disposée une puce semi-conductrice (3), le boîtier en plastique (2) comportant des bords latéraux (13) disposés autour de bords latéraux (14) de la puce semi-conductrice (3),
- une couche de plastique (9 ; 9') électriquement isolante, avec une épaisseur (d) allant jusqu'à 30 µm, en particulier jusqu'à 20 µm, est formée sur la face supérieure active (12) de la puce semi-conductrice (3) et sur les bords latéraux (13) du boîtier en plastique (2) qui sont disposés à côté de la face supérieure active (12) de la puce semi-conductrice (3),
- des contacts extérieurs (7) sont prévus sur une face inférieure (6) du composant électronique,
- les contacts extérieurs (7) sont reliés avec des surfaces de contact (11) sur la face supérieure active (12) de la puce semi-conductrice (3), par des lignes de recâblage (10) disposées dans au moins deux plans de recâblage (31, 32), et par des colonnes de contact (8),
- il est prévu une structure de piste conductrice (19) à plusieurs couches, pour le recâblage des colonnes de contact (8) vers les contacts extérieurs (7), et
- la face inférieure (15) du composant électronique (1) comporte une couche d'arrêt de brasage (16) laissant libres des surfaces de contact extérieur (17) des contacts extérieurs (7).

2. Composant électronique selon la revendication 1, **caractérisé en ce qu'**au moins une autre couche intermédiaire électriquement isolante est prévue entre la couche de plastique (9 ; 9') et le plan de recâblage ou un des plans de recâblage (31, 32).

3. Composant électronique selon la revendication 1 ou la revendication 2,
**caractérisé en ce que**
des contacts extérieurs (7) sont disposés dans des régions situées en-dessous des bords latéraux (13) du boîtier en plastique (2).

4. Composant électronique selon l'une des revendications précédentes,
**caractérisé en ce que**
la face arrière (4) de la puce semi-conductrice (3) est disposée en-dessous de la face supérieure (5) du boîtier en plastique (2), et est recouverte d'un revêtement (26) en masse de boîtier en plastique (9).

5. Composant électronique selon l'une des revendications précédentes,
**caractérisé en ce que**
les contacts extérieurs (7) comportent des billes de soudure (18) ou des bosses de soudure.

6. Procédé pour la fabrication d'un composant électronique (1) avec un boîtier en plastique (2), dans lequel est disposée une puce semi-conductrice (3), le procédé comportant les étapes de procédé suivantes :
- mise à disposition d'une plaquette semi-conductrice (20) avec des puces semi-conductrices (3) disposées en lignes et en colonnes, avec des surfaces de contact (11),
- surhaussement en forme de colonnes des surfaces de contact (11) en colonnes de contact (8) sur la plaquette semi-conductrice (20),
- séparation de la plaquette semi-conductrice (20) en puces semi-conductrices (3) individuelles avec des colonnes de contact (8) sur les surfaces de contact (11),
- équipement d'une plaque de moulage (21) avec les puces semi-conductrices (3),
- fabrication d'un support commun (22) en masse de boîtier en plastique (9) sur la plaque de moulage (21) pour les puces semi-conductrices (3), dans laquelle les puces semi-conductrices (3) sont enrobées de telle manière dans la masse de boîtier en plastique (9), que les faces supérieures (23) des colonnes de contact (8) qui sont opposées aux surfaces de contact (11) sont disposées en restant libres sur la face supérieure (23) du support (22),
- application sélective de lignes de recâblage (10) sur le support commun (22), dans laquelle une extrémité de ligne d'une ligne de recâblage (10) est respectivement reliée à une face supérieure libre (23) d'une colonne de contact (8), et l'autre extrémité de ligne guide une surface de contact extérieur (17),
- application de structures de pistes conductrices (19) à plusieurs couches, sur la face supérieure (24) du support commun (22), pour la fabrication des lignes de recâblage (10) allant des colonnes de contact (8) vers les contacts extérieurs (7) sur la face supérieure des composants électroniques (1),
- application sélective d'un vernis d'arrêt de brasage (16) sur la face supérieure (24) du support (22), en laissant libres les surfaces de contact extérieur (17) des lignes de recâblage (10),
- application de billes de soudure (18) ou de bosses de soudure sur les surfaces de contact extérieur (17),
- séparation du support (22) en composants électroniques (1) individuels.

7. Procédé selon la revendication 6,
**caractérisé en ce que**
la face inférieure (25) de la plaquette semi-conductrice (20) est pourvue d'un revêtement (26) en masse de boîtier en plastique (9) avant la séparation en puces semi-conductrices (3).

8. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé au moyen d'une séparation de métal à travers un masque.

9. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé au moyen d'une séparation de métal électrolytique sélective à travers un masque.

10. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé au moyen d'une technique d'impression.

11. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé au moyen d'une pulvérisation de métal à travers un masque.

12. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé au moyen d'une technique de vaporisation, suivie d'une technique de gravure sélective du métal vaporisé.

13. Procédé selon la revendication 6 ou la revendication 7,
**caractérisé en ce que**
le surhaussement en forme de colonnes des surfaces de contact (11) en colonnes de contact (8) sur la puce semi-conductrice (3) est réalisé par application de têtes de contact, de préférence de têtes de compression thermosoniques, sur les surfaces de contact.

14. Procédé selon l'une des revendications 6 à 13,
**caractérisé en ce que**
la fabrication d'un support commun (22) en masse de boîtier en plastique (9) pour les puces semi-conductrices (3) sur la plaque de moulage (21) est effectuée au moyen d'une technique de moulage par injection, à l'aide d'un moule.

15. Procédé selon l'une des revendications 6 à 14,
**caractérisé en ce que**
la fabrication d'un support commun (22) en masse de boîtier en plastique (9) pour les puces semi-conductrices (3) sur la plaque de moulage (21) est effectuée au moyen d'une technique de coulage centrifuge.

16. Procédé selon l'une des revendications 6 à 15,
**caractérisé en ce que**
l'application sélective de lignes de recâblage (10) sur le support commun (22) en masse de boîtier en plastique (9) est réalisée par application d'une couche métallique fermée, suivie de la structuration de la couche métallique à l'aide d'une technique de photorésine.

17. Procédé selon l'une des revendications 6 à 15,
**caractérisé en ce que**
l'application sélective de lignes de recâblage (10) sur le support commun (22) en masse de boîtier en plastique (9) est réalisée par une technique d'impression, en particulier par une technique d'impression sérigraphique.

18. Procédé selon l'une des revendications 6 à 17,
**caractérisé en ce que**
l'application sélective d'un vernis d'arrêt de brasage (16) sur la face supérieure (24) du support (22) en laissant libres les surfaces de contact extérieur (17) des lignes de recâblage (10), est réalisée au moyen d'une technique de photorésine.

19. Procédé selon la revendication 6,
**caractérisé en ce que**
des procédés de micro-technologie et/ou de technologie de plaques à circuits imprimés sont employés pour la fabrication de structures de pistes conductrices (19) à plusieurs couches.
